Europäisches Patentamt

European Patent Office

Office européen des brevets

(11) Numéro de publication : **0 279 712 B1**

# FASCICULE DE BREVET EUROPEEN

(45) Date de publication du fascicule du brevet :
**18.03.92 Bulletin 92/12**

(51) Int. Cl.$^5$ : **G11C 16/06,** G11C 7/00,
G06F 1/00

(21) Numéro de dépôt : **88400059.7**

(22) Date de dépôt : **13.01.88**

(54) **Circuit de lecture pour mémoire.**

(30) Priorité : **16.01.87 FR 8700449**

(43) Date de publication de la demande :
**24.08.88 Bulletin 88/34**

(45) Mention de la délivrance du brevet :
**18.03.92 Bulletin 92/12**

(84) Etats contractants désignés :
**CH DE ES FR GB IT LI NL**

(56) Documents cités :
**US-A- 4 475 178
IBM TECHNICAL DISCLOSURE BULLETIN,
vol. 14, no. 6, novembre 1971, page 1675, New
York, US; J.E. GERSBACH: "Bipolar bit driver"**

(73) Titulaire : **SGS-THOMSON
MICROELECTRONICS S.A.
101 Boulevard Murat
F-75016 Paris (FR)**

(72) Inventeur : **Kowalski, Jacek Antoni
THOMSON-CSF SCPI 19, avenue de Messine
F-75008 Paris (FR)**

(74) Mandataire : **Ballot, Paul Denis Jacques et al
Cabinet Ballot-Schmit 7, rue le Sueur
F-75116 Paris (FR)**

EP 0 279 712 B1

## Description

La présente invention concerne un circuit de lecture pour une mémoire telle qu'une mémoire non volatile, programmable électriquement, de type EPROM ou EEPROM, ou toute autre mémoire comportant des cellules-mémoire dont la lecture est réalisée par détection d'une variation de courant ou de tension sur la ligne de bit.

Dans le cas, par exemple, des mémoires de type EPROM ou EEPROM, chaque élément de stockage d'informations ou cellules-mémoire est constitué par un transistor MOS à grille flottante qui peut être principalement de type FAMOS (pour floating gate avalanche injection MOS) ou de type SAMOS (pour stacked gate avalanche injection MOS). Ce type de transistor peut avoir deux états. Ainsi, dans le cas d'un transistor MOS à canal n, dans un premier état aucune charge ou une charge positive est piégée sur la grille flottante. Un canal de conduction peut exister entre source et drain. Le transistor conduit alors et se comporte comme un interrupteur fermé. Dans un deuxième état, des électrons sont piégés sur la grille flottante. Ils empêchent donc la création d'un canal de conduction dans le substrat entre source et drain. Dans ce cas, le transistor est bloqué et se comporte comme un interrupteur ouvert.

Pour programmer un transistor MOS à grille flottante, des tensions plus élevées que la tension de fonctionnement normale doivent être convenablement appliquées sur la grille de commande et l'une des électrodes de sorte que la grille flottante puisse absorber et garder une charge d'électrons. Cette charge d'électrons sur la grille flottante augmente le seuil de conduction sur la grille de commande du transistor. D'autre part, pour lire une mémoire ainsi programmée, une tension inférieure à la tension de seuil des transistors MOS à grille flottante programmés mais supérieure à la tension minimale des transistors non programmés, doit être appliquée sur la grille de commande. Cette tension de lecture permet de détecter l'état passant ou bloqué du transistor. En général, le transistor MOS à grille flottante est relié par une de ses électrodes à une ligne de bit polarisée en tension par un générateur. Son autre électrode est reliée à la masse ou à une tension basse. La ligne de bit est également connectée à un senseur de courant ou de tension. Ce senseur mesure le courant débité dans la ligne par le générateur. Ainsi, si la cellule mémoire n'a pas été programmée, le transistor MOS à grille flottante est passant et lors de l'application d'une tension de lecture qui est supérieure à la tension de seuil des transistors non programmés, le transistor est mis en conduction. On détecte alors sur le senseur une variation du courant ou une chute de la tension. Dans le deuxième cas, lorsque la cellule-mémoire a été programmée, des charges sont piègées sur la grille flottante du transistor. La tension de lecture appliquée sur la grille de commande est, dans ce cas, de sens opposé à la barrière de potentiel créée dans le canal de conduction par les charges stockées dans la grille flottante. Mais elle est alors insuffisante pour modifier la conduction du canal et le transistor reste bloqué. En conséquence, le senseur en bout de la ligne de bit ne perçoit pas de variation de courant ou de la tension.

Ainsi, avec une mémoire de type EPROM telle que décrite ci-dessus, il est possible de lire le contenu d'une cellule-mémoire d'après la consommation du circuit, en particulier lorsque la mémoire est lue bit par bit.

Ceci est particulièrement gênant dans le cas des mémoires utilisées pour recevoir des informations confidentielles, car il est alors facile de détecter lors de la lecture la teneur de ces informations.

La présente invention a pour but de remédier à cet inconvénient en proposant un circuit de lecture qui présente toujours une consommation de courant quel que soit l'état programmé ou non programmé de la cellule-mémoire lue.

La présente invention a en conséquence pour objet un circuit de lecture pour circuit intégré du type circuit logique comportant une mémoire constituée par une matrice de cellules-mémoire dont la lecture est réalisée par détection d'une variation de courant ou de tension, les cellules-mémoire étant adressables chacune par des lignes et des colonnes sélectionnées par des décodeurs de ligne et de colonne, le circuit de lecture étant adapté à être relié aux cellulles-mémoire par une ligne appelée ligne de bit et comprenant un circuit de précharge de la ligne de bit et un premier circuit de détection détectant la conduction ou la non conduction de la cellule-mémoire adressée, caractérisé en ce qu'il comporte en parallèle avec le premier circuit de détection un deuxième circuit de détection identique, les deux circuits de détection étant connectés à un noeud commun de la ligne de bit par des moyens agencés pour que les deux circuits de détection réagissent de manières complémentaires pour un même état de la ligne de bit, de sorte que quel que soit l'état de la ligne de bit la consommation globale de courant reste constante.

Différents modes de réalisation peuvent être utilisés pour ce circuit de lecture.

Selon un premier mode de réalisation, le circuit de lecture comporte un premier circuit de précharge de la ligne de bit, un premier moyen formant interrupteur connecté entre le premier circuit de précharge et le premier circuit de détection, un deuxième moyen formant interrupteur connecté par l'intermédiaire d'un inverseur entre le premier circuit de précharge et le deuxième circuit de détection, les moyens formant interrupteur étant commandés par un signal de validation de lecture et des deuxième et troisième circuits de précharge réalisant une précharge de même niveau logique que le premier circuit de précharge étant connectés respectivement entre chaque moyen formant interrupteur et le circuit de détection correspondant.

Selon un autre mode de réalisation, le circuit de lecture comporte un premier circuit de précharge de la ligne de bit, un premier moyen formant interrupteur connecté entre le premier circuit de précharge et le premier circuit de détection, un deuxième moyen formant interrupteur connecté entre le premier circuit de précharge et le deuxième circuit de détection, les moyens formant interrupteur étant commandés respectivement par un signal de validation de lecture et par ce signal inversé, un deuxième circuit de précharge réalisant une précharge au même niveau logique que le premier circuit de précharge étant connecté entre le premier moyen formant interrupteur et le premier circuit de détection et un troisième circuit de précharge réalisant une précharge au niveau logique inverse étant connecté entre le deuxième moyen formant interrupteur et le deuxième circuit de détection.

D'autres caractéristiques et avantages de la présente invention apparaîtront à la lecture de la description de divers modes de réalisation faite ci-après avec référence aux dessins ci-annexés dans lesquels :
  – la figure 1 représente schématiquement une mémoire EPROM comportant un circuit de lecture,
  – les figures 2A et 2B représentent schématiquement un premier mode de réalisation d'un circuit de lecture conforme à la présente invention, ainsi qu'un diagramme des temps des principaux signaux de commande de ce circuit,
  – les figures 3A et 3B représentent schématiquement un autre mode de réalisation d'un circuit de lecture conforme à la présente invention, ainsi qu'un diagramme des temps des principaux signaux de commande de ce circuit, et
  – les figures 4A et 4B représentent respectivement un mode de réalisation des circuits de détection et la courbe tension-courant de ce circuit.

Pour simplifier la description, dans les dessins les mêmes éléments portent les mêmes références. D'autre part, la description a été faite en se référant à des circuits MOS réalisés en technologie CMOS, il est évident pour l'homme de l'art que la présente invention peut s'adapter à d'autres technologies, notamment à la technologie N MOS.

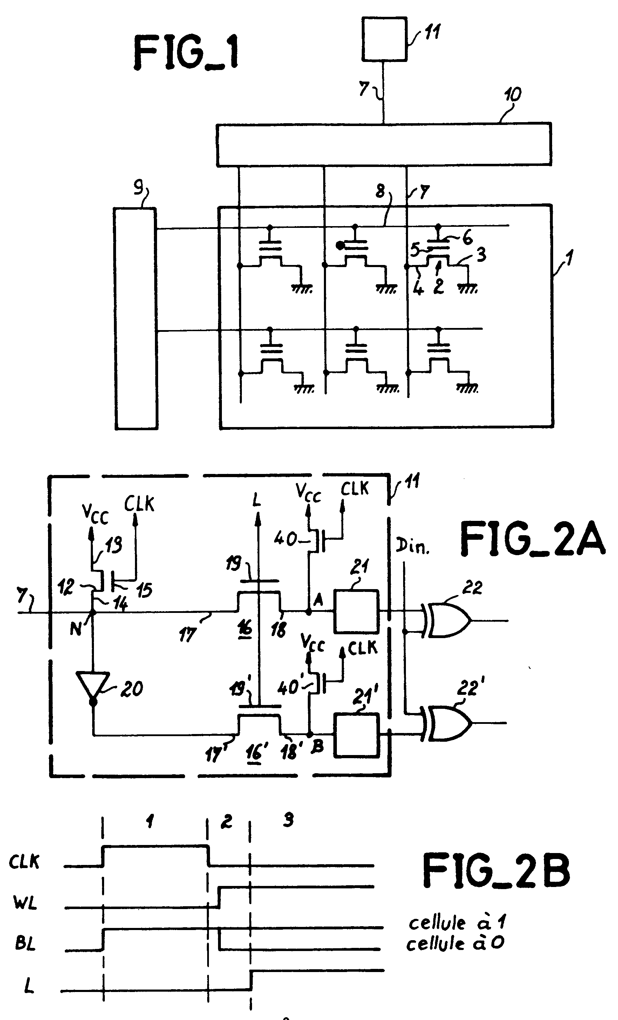

Sur la figure 1, on a représenté une mémoire 1 non volatile programmable électriquement de type EPROM. Cette mémoire est du type à cellule mémoire constituée d'un transistor MOS 2 à grille flottante 5. De manière plus spécifique, le transistor 2 comporte deux électrodes principales respectivement 3 et 4, une grille flottante 5 et une grille de commande 6. Une première électrode principale, à savoir la source dans le mode de réalisation représenté, est reliée à la masse tandis que l'autre électrode 4, à savoir le drain, est reliée à une ligne 7 appelée ligne de bit. La grille de commande 6 est reliée à une autre connection 8 appelée ligne de mot. Les lignes de bit et lignes de mot sont disposées en lignes et en colonnes pour déterminer une matrice incluant les cellules-mémoire comme représenté sur la figure 1. Cette mémoire comporte des moyens constitués essentiellement par un décodeur de ligne 9 et un décodeur de colonne 10, pour appliquer sur les lignes et les colonnes des potentiels représentatifs d'informations à enregistrer dans les cellules-mémoire ou représentatifs de commande de lecture des informations enregistrées dans les cellules-mémoire. Ainsi, pour la lecture d'une cellule-mémoire, on fait monter la ligne de mot correspondante 8 à une tension produite par une sortie du décodeur de ligne 9. Au moyen du décodeur de colonne 10, on envoie sur la ligne de bit 7 correspondante une impulsion de commande. Le transistor MOS 2 devient passant ou reste bloqué selon que les charges n'ont pas ou ont été au préalable piégée sur sa grille flottante 5. Un circuit de lecture 11 connecté par ailleurs à une extrémité de la ligne de bit 7 par l'intermédiaire du décodeur de colonne 10 formant multiplexeur, détecte la variation ou l'absence de variation de courant. Il en déduit que la cellule-mémoire est programmée à "1" ou à "0" respectivement.

On décrira maintenant, avec référence à la figure 2A, un premier mode de réalisation d'un circuit de lecture conforme à la présente invention. Ce circuit de lecture 11 comporte tout d'abord un circuit de précharge de la ligne de bit 7. Ce circuit de précharge est constitué par un transistor MOS 12 de type N dans le mode de réalisation représenté, dont une des électrodes 13 est reliée à la tension d'alimentation $V_{cc}$ et dont l'autre électrode principale 14 est connectée à un noeud N sur la ligne de bit 7. D'autre part, la grille 15 du transistor MOS 12 est reliée à l'horloge CLK de la mémoire EPROM. De plus, le circuit de lecture conforme à la présente invention est constitué de deux branches parallèles. La première branche comporte un premier moyen formant interrupteur constitué par un transistor MOS 16 de type N dont une des électrodes principales 17 est connectée au noeud N de la ligne de bit 7 et dont l'autre électrode principale 18 est reliée à l'entrée d'un premier circuit de détection 21 dont la sortie donne la donnée lue. La grille 19 du transistor MOS 16 est connectée à un signal de validation de lecture L qui peut être par exemple le signal de commande de lecture WL appliqué sur la grille de la cellule-mémoire retardé.

D'autre part, la deuxième branche du circuit de lecture est constituée essentiellement d'un deuxième moyen formant interrupteur constitué par un transistor MOS 16' identique au transistor MOS 16 dont une des électrodes principales 17' est connectée par l'intermédiaire d'un inverseur 20 au noeud N de la ligne de bit 7 et dont l'autre électrode 18' est reliée en entrée d'un deuxième circuit de détection 21' identique au circuit 21. Les circuits de détection 21 et 21' peuvent être constitués par deux inverseurs en série. La grille 19' du transistor MOS 16' est connectée au signal de validation de lecture L. Cette seconde branche simule une détection inverse de la détection obtenue sur la première branche de manière à obtenir simultanément à chaque lecture la détection d'un "1" et d'un "0" quel que soit l'état de la cellule-mémoire adressée, comme cela sera expliqué de manière plus détaillée ci-après. D'autre part, au noeud A entre le transistor MOS 16 et le circuit de détection 21 est connecté un deuxième circuit de précharge constitué d'un transistor MOS 40 de type N dont une des électrodes est reliée au noeud A, l'autre électrode à la tension $V_{cc}$ et la grille au signal horloge CLK. CE circuit de précharge réalise une précharge au même niveau logique que le premier circuit de précharge constitué par le transistor MOS 12. De plus, au noeud B entre le transistor MOS 16' et le circuit de détection 21' est connecté un troisième circuit de précharge constitué d'un transistor MOS 40' de type N dont une des électrodes est connectée au noeud A, l'autre électrode à la tension $V_{cc}$ et la grille au signal horloge CLK. Selon un autre mode de réalisation, les circuits de précharge 12, 40, 40' peuvent être réalisés par des transistors MOS de type P, dans ce cas les grilles sont connectées à un signal $\overline{CLK}$.

Selon un mode de réalisation spécifique à une mémoire en logique câblée, les données obtenues en sortie des circuits de détection 21 et 21' sont envoyées sur des comparateurs constitués par des OU exclusif 22, 22' qui reçoivent en entrée une donnée Din à comparer avec la donnée lue, notamment dans le cadre de la comparaison d'un code confidentiel. Le résultat obtenu en sortie du OU exclusif 22 donne le résultat recherché. On peut également remplacer les portes logiques OU exclusif par d'autres portes bloquées par une horloge qui sera activée à la fin de la lecture.

On expliquera maintenant le fonctionnement du circuit décrit ci-dessus à l'aide du diagramme des temps de la figure 2B.

Avec le circuit ci-dessus, lorsque le signal CLK est au niveau logique "1", c'est-à-dire pendant le temps 1 du diagramme, les transistors MOS 12, 40 et 40' sont conducteurs et l'on réalise une précharge des noeuds N, A et B à $V_{cc}-V_T$, c'est-à-dire à un niveau logique "1". Lorsque le signal CLK repasse au niveau logique "0", on active la grille de commande 6 du transistor MOS 2 à grille flottante en lui appliquant le signal WL et suivant l'état de la cellule mémoire, on décharge ou non la ligne de bit 7 comme représenté par le signal BL. Ainsi, si la cellule-mémoire constituée par le transistor MOS 2 à grille flottante n'a pas été programmée (pas d'électrons sur la grille flottante), le transistor est passant et lors de l'application de la tension de lecture $W_L$ correspondant à la tension d'alimentation, le transistor est mis en conduction.

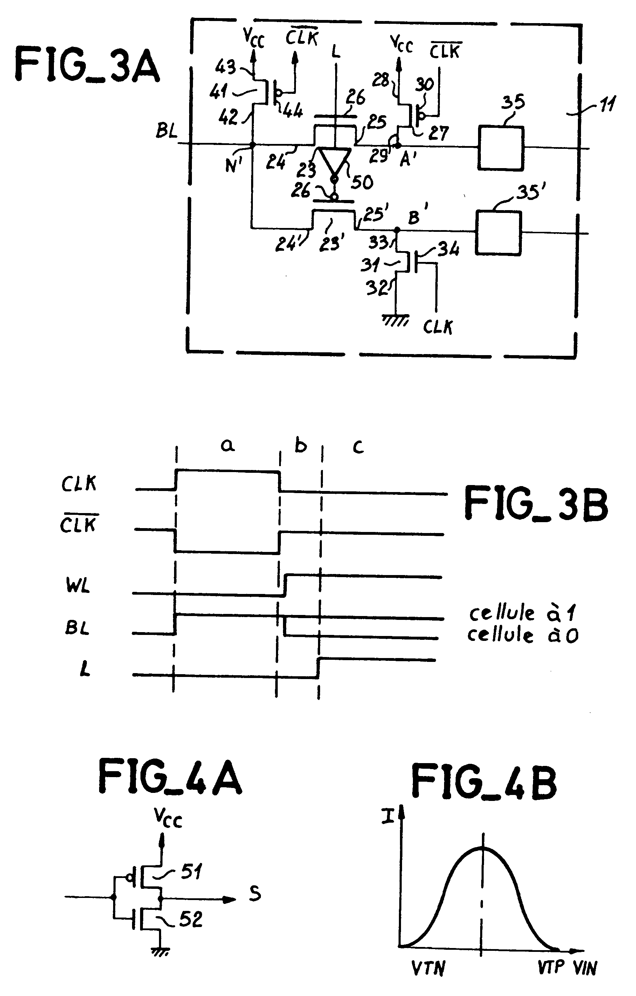

Dans ce cas il y a décharge de la ligne de bit 7 et l'électrode 17 se trouve être à un niveau logique "0" tandis que l'électrode 17' se trouve être à un niveau logique "1" du fait de l'inverseur 20. Lorsque le signal L passe an niveau logique "1" comme représenté par 3 sur le diagramme de la figure 3A, le noeud A se positionne au niveau logique "0" entraînant le basculement du circuit de détection 21 tandis que le noeud B reste positionné au niveau "1". Si, par contre le transistor à grille flottante a été programmé, il n'y a pas décharge de la ligne de bit 7. Le noeud N reste au niveau logique "1" tandis que l'électrode 17' en sortie de l'inverseur 20 se trouve être à un niveau logique "0". Lorsque le signal L passe à "1", le noeud A reste inchangé à "1" tandis que le noeud B passe à "0". Dans ce cas, seul le circuit de détection 21' bascule. Les deux circuits étant identiques, la consommation est donc identique dans le cas de la lecture d'un "0" ou d'un "1".

On décrira maintenant, avec référence à la figure 3A, un autre mode de réalisation d'un circuit de lecture conforme à la présente invention. Ce circuit de lecture comporte un premier circuit de précharge constitué d'un transistor MOS 41 de type P dont une électrode 42 est connectée au noeud N' de la ligne de bit 7, la deuxième électrode à la tension $V_{cc}$ et la grille au signal horloge inversé $\overline{CLK}$. D'autre part, le circuit de lecture comporte une première branche avec un premier moyen formant interrupteur constitué d'un transistor MOS 23 de type N dont une des électrodes principales 24 est reliée au niveau du noeud N' à la ligne de bit 7, et dont l'autre électrode principale 25 est connectée à un premier circuit de détection 35. La grille 26 du transistor MOS 23 est reliée à un signal de validation de lecture L. Un circuit de précharge est connecté au noeud A' en sortie du transistor MOS 23. De manière plus spécifique, ce circuit de précharge est constitué, dans le mode de réalisation représenté, d'un transistor MOS de type P 27 dont une des électrodes principales 28 est reliée à la tension d'alimentation $V_{cc}$ et dont l'autre électrode 29 est connectée au noeud A' entre l'électrode 25 du transistor MOS 23 et le circuit 35. La grille 30 du transistor MOS 27 est reliée au signal horloge inversé $\overline{CLK}$. D'autre part, le circuit de lecture 11 comporte une deuxième branche avec un deuxième moyen formant interrupteur constitué d'un transistor MOS 23' de type P dont une des électrodes principales 24' reliée au niveau du noeud N' à la ligne de bit 7 et dont l'autre électrode principale 25' est connectée à un deuxième circuit de détection 35'. La grille 26' du transistor MOS 23' est reliée par l'intermédiaire d'un inverseur 50 au signal de validation de lecture L. D'autre part, un circuit de précharge est connecté au noeud B' entre l'électrode 25' et le circuit 35'. Ce circuit de précharge est constitué d'un transistor MOS 31 de type N dont une des électrodes principales 32 est connectée à la masse $V_{ss}$ tandis que son autre électrode principale 33 est reliée au noeud B'. La grille 34 du transistor MOS 31 est connectée au signal horloge CLK.

On expliquera ci-après le fonctionnement de ce circuit de lecture en se référant au diagramme des temps de la figure 3B.

Pendant le temps a, les signaux horloge CLK et $\overline{CLK}$ sont respectivement aux niveaux logiques "1" et "0". De ce fait, les noeuds N' et A' sont préchargés à la tension d'alimentation $V_{cc}$ tandis que le noeud B' est préchargé à la masse $V_{ss}$.

Pendant le temps b, l'ordre de lecture WL appliqué sur la grille du transistor MOS à grille flottante constituant la cellule-mémoire passe à "1". Pendant cette période on lit le contenu de la cellule-mémoire. Le noeud N' soit reste à $V_{cc}$ soit se décharge à $V_{ss}$ suivant le contenu de la cellule-mémoire, comme représenté par le signal BL.

Pendant le temps c, le signal de validation de lecture L est positionné à "1". Si le noeud N' n'a pas été déchargé, le noeud A' reste positionné à la tension $V_{cc}$, tandis que le noeud B' bascule à la tension $V_{cc}$. Au contraire, si le noeud N' a été déchargé, le noeud A' bascule à la masse $V_{ss}$, tandis que le noeud B' reste postionné à la masse $V_{ss}$.

Les circuits de détection 35, 35' sont, dans ce mode de réalisation, composés d'inverseurs en technologie C MOS du type de celui représenté sur la figure 4 A.

Cet inverseur est constitué, de manière connue, d'un transistor MOS 51 de type P dont une des électrodes est connectée à $V_{cc}$ et dont l'autre électrode est connectée à une des électrodes d'un transistor MOS 52 de type N dont l'autre électrode est connectée à la masse $V_{ss}$. Les deux grilles sont reliées ensemble et connectées à la tension d'entrée $V_{IN}$ et la sortie S est obtenue sur le noeud entre les deux transistors.

La courbe de consommation d'un inverseur C MOS est représentée sur la figure 4B. D'après cette courbe on voit que la consommation est la même lorsque $V_{IN}$ passe de $V_{cc}$ à $V_{ss}$ ou lorsque $V_{IN}$ passe de $V_{ss}$ à $V_{cc}$. Cette propriété est utilisée dans le circuit de la figure 3A pour obtenir le résultat recherché, c'est-à-dire un consommation de courant identique quel que soit l'état d'une cellule-mémoire.

Les modes de réalisation décrits ci-dessus ont été donnés à titre d'exemple. Il est évident pour l'homme de l'art qu'ils peuvent être modifiés notamment au niveau du type de transistors MOS utilisés pour les circuits de précharge ou les circuits formant interrupteur.

D'autre part, la présente invention a été décrite en se référant à une mémoire EPROM, il est évident qu'elle peut s'appliquer à une mémoire EEPROM ou à toute mémoire dont les cellules-mémoire sont lues en détectant une variation de courant ou de tension sur la ligne de bit.

**Revendications**

1. Circuit de lecture pour circuit intégré du type circuit logique comportant une mémoire (1) constituée par une matrice de cellules-mémoire dont la lecture est réalisée par détection d'une variation de courant ou de tension, les cellules-mémoire étant adressables chacune par des lignes et des colonnes sélectionnées par des décodeurs de ligne (9) et de colonne (10), le circuit de lecture (11) étant adapté à être relié aux cellules-mémoire par une ligne appelée lignes de bit (7) et comprenant un circuit de précharge (12, 41) de la ligne de bit et un premier circuit de détection (21, 35) détectant la conduction ou la non-conduction de la cellule-mémoire adressée, caractérisé en ce qu'il comporte en parallèle avec le premier circuit de détection un deuxième circuit de détection identique (21', 35'), les deux circuits de détection étant connectés à un noeud commun (N, N') de la ligne de bit par des moyens (20, 16 16', 40, 40', 23, 23', 27, 31, 50) agencés pour que les deux circuits de détection réagissent de manières complémentaires pour un même état de la ligne de bit, de sorte que quel que soit l'état de la ligne de bit la consommation globale de courant reste constante.

2. Circuit de lecture selon la revendication 1, caractérisé en ce qu'il comporte un premier circuit de précharge (12) de la ligne de bit (7), un premier moyen formant interrupteur (16) connecté entre le premier circuit de précharge et le premier circuit de détection (21), un deuxième moyen formant interrupteur (16') connecté par l'intermédiaire d'un inverseur (20) entre le premier circuit de précharge et le deuxième circuit de détection (21'), les moyens formant interrupteur étant commandés par un signal de validation de lecture (L), des deuxième et troisième circuits de précharge (40, 40') réalisant une précharge de même niveau logique que le premier circuit de précharge étant connectés respectivement entre chaque moyen formant interrupteur et le circuit de détection correspondant.

3. Circuit de lecture selon la revendication 1, caractérisé en ce qu'il comporte un premier circuit de précharge (41) de la ligne de bit, un premier moyen formant interrupteur (23) connecté entre le premier circuit de précharge et le premier circuit de détection (35), un deuxième moyen formant interrupteur (23') connecté entre le premier circuit de précharge et le deuxième circuit de détection (35'), les moyens formant interrupteur étant commandés respectivement par un signal de validation de lecture (L) et par ce signal inversé, un deuxième circuit de précharge (27) réalisant une précharge au même niveau logique que le premier circuit de précharge étant connecté entre le premier moyen formant interrupteur (23) et le premier circuit de détection (35) et un troisième circuit de précharge réalisant une précharge an niveau logique inverse étant connecté entre le deuxième moyen formant interrupteur (23′) et le deuxième circuit de détection (35′).

4. Circuit de lecture selon l'une quelconque des revendications 2 et 3, caractérisé en ce que les moyens formant interrupteurs (16, 16′, 23, 23′) sont constitués par des transistors MOS.

5. Circuit de lecture selon l'une quelconque des revendications 2 et 3, caractérisé en ce que les circuits de détection sont constitués par deux inverseurs MOS.

6. Circuit de lecture selon la revendication 2, caractérisé en ce que les circuits de précharge (12, 40, 40′) sont identiques et constitués chacun par un transistor MOS de type N dont une des électrodes principales est connectée à la tension d'alimentation $V_{cc}$, l'autre électrode principal au noeud à charger et la grille au signal horloge CLK.

7. Circuit de lecture selon la revendication 2, caractérisé en ce que les circuits de précharge (12, 40, 40′) sont identiques et consitués chacun par un transistor MOS′ de type P dont une des électrodes principales est connectée à la tension d'alimentation $V_{cc}$, l'autre électrode principale au noeud à charger et la grille au signal horloge inversé $\overline{CLK}$.

8. Circuit de lecture selon la revendication 3, caractérisé en ce que le premier et le deuxième circuit de précharge sont constitués chacun par un transistor MOS (27, 41) de type P dont une (28, 43) des électrodes principale est connectée à la tension d'alimentation $V_{cc}$, l'autre électrode principale (29, 42) au noeud à charger et la grille (30, 44) au signal horloge inversé $\overline{CLK}$ et le troisième circuit de précharge est constitué par un transistor MOS (31) de type N dont une (32) des électrodes principales est connectée à la masse $V_{ss}$, l'autre électrode principale (33) au noeud à charger et la grille (34) au signal d'horloge CLK.

9. Circuit de lecture selon l'une quelconque des revendications 2 à 8, caractérisé en ce que le signal de validation de lecture (L) est constitué par l'ordre de lecture (WL) appliqué sur la cellule-mémoire retardé.

**Patentansprüche**

1. Leseschaltung für integrierte Schaltungen vom Typ einer Logikschaltung, mit einem Speicher (1), der von einer Matrix von Speicherzellen gebildet wird, die dadurch gelesen werden, daß eine Strom- oder Spannungsschwankung erfaßt wird, wobei die Speicherzellen jeweils durch Zeilen und Spalten adressierbar sind, die von einem Zeilendekoder (9) und einem Spaltendekoder (10) ausgewählt werden, wobei die Leseschaltung (11) so beschaffen ist, daß sie mit den Speicherzellen über eine als Bit-Leitung (7) bezeichnete Leitung verbunden ist und eine Vorbelastungsschaltung (12, 41) für die Bit-Leitung und eine erste Erfassungsschaltung (21, 35), die den leitenden oder den nichtleitenden Zustand der adressierten Speicherzelle erfaßt, aufweist, dadurch gekennzeichnet, daß sie parallel zur ersten Erfassungsschaltung eine identische zweite Erfassungsschaltung (21′, 35′) aufweist, wobei die zwei Erfassungsschaltungen mit einem gemeinsamen Knoten (N, N′) der Bit-Leitung durch Mittel (20, 16, 16′, 40, 40′, 23, 23′, 27, 31, 50) verbunden sind, die so angeordnet sind, daß die zwei Erfassungsschaltungen bei gleichem Zustand der Bit-Leitung auf komplementäre Weise ansprechen, derart, daß unabhängig vom Zustand der Bit-Leitung der Gesamtstromverbrauch konstant bleibt.

2. Leseschaltung gemäß Anspruch 1, dadurch gekennzeichnet, daß sie eine erste Vorbelastungsschaltung (12) für die Bit-Leitung (7), ein erstes einen Unterbrecher (16) bildendes Mittel, das zwischen die erste Vorbelastungsschaltung und die erste Erfassungsschaltung (21) geschaltet ist, und ein zweites einen Unterbrecher (16′) bildendes Mittel, das über einen dazwischengeschalteten Invertierer (20) zwischen die erste Vorbelastungsschaltung und die zweite Erfassungsschaltung (21′) geschaltet ist, umfaßt, wobei die die Unterbrecher bildenden Mittel von einem Lese-Validierungssignal (L) gesteuert werden, wobei eine zweite und eine dritte Vorbelastungsschaltung (40, 40′), die eine Vorbelastung mit demselben Logikpegel wie die erste Vorbelastungsschaltung erzeugen, zwischen das jeweilige den Unterbrecher bildende Mittel und die entsprechende Erfassungsschaltung geschaltet sind.

3. Leseschaltung gemäß Anspruch 1, dadurch gekennzeichnet, daß sie eine erste Vorbelastungsschaltung (41) der Bit-Leitung, ein erstes einen Unterbrecher (23) bildendes Mittel, das zwischen die erste Vorbelastungsschaltung und die erste Erfassungsschaltung (35) geschaltet ist, und ein zweites einen Unterbrecher (23′) bildendes Mittel, das zwischen die erste Vorbelastungsschaltung und die zweite Erfassungsschaltung (35′) geschaltet ist, umfaßt, wobei die die Unterbrecher bildenden Mittel jeweils von einem Lese-Validierungssignal (L) und von einem Signal, das sich durch die Invertierung des Lese-Validierungssignals (L) ergibt, gesteuert werden, wobei eine zweite Vorbelastungsschaltung (27), die eine Vorbelastung mit demselben Logikpegel wie die erste Vorbelastungsschaltung erzeugt, zwischen das erste einen Unterbrecher (23) bildende Mittel und die erste Erfassungsschaltung (35) geschaltet ist und eine dritte Vorbelastungsschaltung, die eine Vorbelastung mit inversen Logikpegeln erzeugt, zwischen das zweite einen Unterbrecher (23′) bildende Mittel und die zweite Erfassungsschaltung (35′) geschaltet ist.

4. Leseschaltung gemäß einem der Ansprüche 2 und 3, dadurch gekennzeichnet, daß die die Unterbrecher (16, 16′, 23, 23′) bildenden Mittel von MOS-Transistoren gebildet werden.

5. Leseschaltung gemäß einem der Ansprüche 2 und 3, dadurch gekennzeichnet, daß die Erfassungsschaltungen von zwei MOS-Invertierern gebildet werden.

6. Leseschaltung gemäß Anspruch 2, dadurch gekennzeichnet, daß die Vorbelastungsschaltungen (12, 40, 40′) identisch sind und jeweils von einem N-Kanal-MOS-Transistor gebildet werden, dessen eine Hauptelektrode mit der Versorgungsspannung $V_{cc}$ verbunden ist, dessen andere Hauptelektrode mit dem Vorbelastungsknoten verbunden ist und dessen Gate mit dem Taktsignal CLK verbunden ist.

7. Leseschaltung gemäß Anspruch 2, dadurch gekennzeichnet, daß die Vorbelastungsschaltungen (12, 40, 40′) identisch sind, und jeweils von einem P-Kanal-MOS-Transistor gebildet werden, dessen eine Hauptelektrode mit der Versorgungsspannung $V_{cc}$ verbunden ist, dessen andere Hauptelektrode mit dem Vorbelastungsknoten verbunden ist und dessen Gate mit dem invertierten Taktsignal $\overline{CLK}$ verbunden ist.

8. Leseschaltung gemäß Anspruch 3, dadurch gekennzeichnet, daß die erste und die zweite Vorbelastungsschaltung jeweils von einem P-Kanal-MOS-Transistor (27, 41) gebildet werden, dessen eine Hauptelektrode (28, 43) mit der Versorgungsspannung $V_{cc}$ verbunden ist, dessen andere Hauptelektrode (29, 42) mit dem Vorbelastungsknoten verbunden ist und dessen Gate (30, 44) mit dem invertierten Taktsignal $\overline{CLK}$ verbunden ist und die dritte Vorbelastungsschaltung von einem N-Kanal-MOS-Transistor (31) gebildet wird, dessen eine Hauptelektrode (33) mit Masse $V_{ss}$ verbunden ist, dessen andere Hauptelektrode (33) mit dem Vorbelastungsknoten verbunden ist und dessen Gate (34) mit dem Taktsignal CLK verbunden ist.

9. Leseschaltung gemäß einem der Ansprüche 2 bis 8, dadurch gekennzeichnet, daß das Lese-Validierungssignal (L) vom Lesebefehl (WL) gebildet wird, der verzögert an die Speicherzelle gegeben wird.

**Claims**

1. A read circuit for an integrated circuit of the logic type comprising a memory (1) constituted by a matrix of memory cells which is read by the detection of a variation in current or in voltage, the memory cells each being able to be addressed by lines and columns selected by line decoders (9) and column decoders (10), the read circuit (11) being adapted to be connected with the memory cells by a bit line (7) and comprising a bias circuit (12 and 41) for the bit line and a first detection circuit (21 and 35) detecting the conduction or the non-conduction of the addressed memory cell, characterized in that it comprises, in parallel with the first detection circuit, a second identical detection circuit (21′ and 35′), the two detection circuits being connected with a common point (N and N′) of the bit line by means (20, 16, 16′, 40, 40′, 23, 23′, 27, 31 and 50′) operated so that the two detection circuits react in complementary manners for a given state of the bit line in such a manner that whatever the state of the bit line the overall current used remain constant.

2. The read circuit as claimed in claim 1, characterized in that it comprises a first bias circuit (12) for the bit line (7), a first means constituting a switch (16) connected between the first bias circuit and the first detection circuit (21), a second means constituting a switch (16′) connected by means of an inverter (20) between the first bias circuit and the second detection circuit (21′), the means constituting the switch being controlled by a read enable signal (L), the second and the third bias circuits (40 and 40′) producing a bias at the same logic level as the first bias circuit being respectively connected between each means constituting a switch and the corresponding detection circuit.

3. The read circuit as claimed in claim 1, characterized in that it comprises a first bias circuit (41) for the bit line, a first means constituting a switch (23) connected between the first bias circuit and the first detection circuit (35), a second means constituting a switch (23′) connected between the first bias circuit and the second detection circuit (35′), the means constituting a switch being controlled respectively by a read enable signal (L) and by the inverted signal, a second bias circuit (27) producing a bias at the same logical level as the first bias circuit being connected between the first means constituting a switch (23) and the first detection circuit (35) and a third bias circuit producing a bias at the inverse logic level being connected between the second means constituting a switch (23′) and the second detection circuit (35′).

4. The read circuit as claimed in claim 2 or in claim 3, characterized in that the means constituting switches (16, 16′, 23 and 23′) are constituted by MOS transistors.

5. The read circuit as claimed in claim 2 or in claim 3, characterized in that the detection circuits are constituted by two MOS inverters.

6. The read circuit as claimed in claim 2, characterized in that the bias circuits (12, 40 and 40′) are identical and are each constituted by an N type MOS transistor one of whose main electrodes is connected with the supply voltage $V_{cc}$, the other main electrode is connected with the point to be loaded and the gate is connected with the clock signal CLK.

7. The read circuit as claimed in claim 2, characterized in that the bias circuits (12, 40 and 40′) are identical and are each constituted by a P type MOS transistor one of whose main electrodes is connected with the supply voltage $V_{cc}$, the other main electrode is connected with the point to be loaded and the gate is connected with the inverted clock signal $\overline{CLK}$.

8. The read circuit as claimed in claim 3, characterized in that the first and the second bias circuits are each constituted by a P type MOS transistor (27 and 41) of which one of the main electrodes (28 and 43) is connected with the supply voltage $V_{cc}$, the other main electrode (29 and 42) is connected with the point to be loaded and the gate (30 and 44) is connected with the inverted clock signal $\overline{CLK}$ and the third bias circuit is constituted by an N type MOS transistor (31) whose one main electrode (32) is connected with ground $V_{ss}$, the other main electrode (33) is connected with the point to be loaded and the gate (34) is connected with the clock signal.

9. The read circuit as claimed in any one of the preceding claims 2 through 8, characterized in that the read enable signal (L) is constituted by the read command (WL) applied to the delayed memory cell.

# FIG_1

# FIG_2A

# FIG_2B

cellule à 1
cellule à 0

FIG_3A

FIG_3B

FIG_4A

FIG_4B